# FASCICULE DE BREVET EUROPEEN

(11) **EP 0 937 992 B1**
(45) Date de publication et mention de la délivrance du brevet: **17.05.2006**
(21) Numéro de dépôt: 99400170.9
(22) Date de dépôt: 25.01.1999
(51) Int. Cl.: G01R 31/36

(54) **Procédé et système de surveillance de l'état de charge d'une batterie d'automobile**
Verfahren und System zur Ladezustandsüberwachung einer Kraftfahrzeugbatterie
Procedure and system for monitoring the state of charge of a motor vehicle

(30) Priorité: 19.02.1998 FR 9802028
(43) Date de publication de la demande: 25.08.1999
(73) Titulaire: AUTOMOBILES PEUGEOT, 75116 Paris (FR); AUTOMOBILES CITROEN, 92200 Neuilly-sur-Seine (FR)
(72) Inventeur: Burguburu, Philippe, 78000 Versailles (FR)
(74) Mandataire: Berger, Helmut

(56) Documents cités:
- EP-A- 0 356 347
- DE-A- 4 225 514
- GB-A- 2 258 736
- US-A- 5 596 261

## Description

L'invention concerne un procédé de surveillance de l'état de charge d'une batterie, notamment d'un véhicule automobile équipé d'un calculateur de bord, et un dispositif de surveillance pour la mise en oeuvre de ce procédé, selon le préambule des revendications 1 et 7.

Un procédé de ce type est déjà connu par le document DE 42 25 514. Mais, selon ce procédé, on affiche de façon permanente l'état de charge de la batterie sous forme d'un clignotement spécifique des différents états de charge.

Le document GB 2 258 736 décrit un procédé de vérification à distance de l'état de charge d'une batterie, mais selon lequel l'indication de l'état de charge se fait à distance par l'envoi d'un signal de commande par un émetteur extérieur. Cependant ce procédé prévoit le renvoi à l'émetteur, pour l'affichage, l'information sur l'état de charge, ce qui implique que la batterie doit être équipée de moyens émetteurs de l'information et l'émetteur extérieur d'un dispositif d'affichage de ces informations, ce qui a pour inconvénient que le dispositif de mise en oeuvre de ce procédé connu doit être complexe.

L'invention a pour but de proposer un procédé et un dispositif de mise en oeuvre de celui-ci, qui pallie les inconvénients qui viennent d'être énoncés.

Pour atteindre ce but, le procédé selon l'invention et son dispositif de mise en oeuvre comportent les caractéristiques qui sont énoncées dans les parties caractérisantes des revendications 1 et 7.

L'invention sera mieux comprise et d'autres buts, caractéristiques, détails et avantages de celle-ci apparaîtront plus clairement dans la description explicative qui va suivre faite en référence aux dessins schématiques annexés donnés uniquement à titre d'exemple illustrant un mode de réalisation de l'invention et dans lesquels :
La figure 1 est une vue schématique du véhicule et du dispositif extérieur émetteur de signaux de demande de mesure de la tension de la batterie du véhicule.
La figure 2 est un schéma bloc du système selon l'invention.

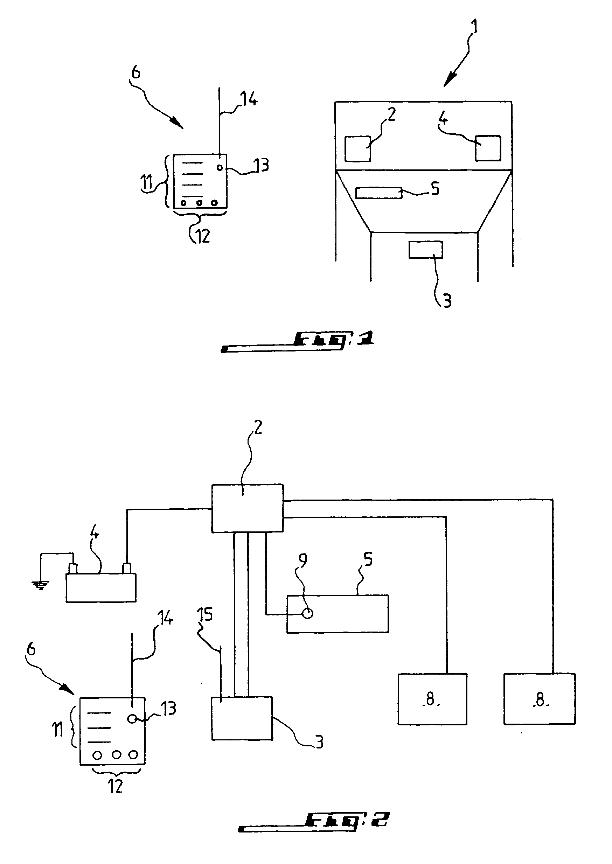

Sur la figure 1, le numéro de référence 1 désigne de façon globale le véhicule qui est équipé d'un calculateur de bord 2 et d'un récepteur 3 de télécommande de verrouillage et de déverrouillage du véhicule. Le numéro de référence 4 désigne la batterie du véhicule et 5 le combiné sur la planche de bord. Le numéro de référence 6 indique un dispositif émetteur extérieur qui permet d'envoyer des signaux de demande de mesure de la tension de la batterie 4 à l'ordinateur de bord 2, par l'intermédiaire du récepteur de télécommande 3.

La figure 2 montre que la batterie 4, le récepteur de télécommande 3 et le combiné 5 sont reliés au calculateur de bord 2. La figure montre aussi en 8 deux appareils ou organes du véhicule dont l'alimentation en énergie électrique à partir de la batterie 4 par l'intermédiaire du calculateur doit pouvoir être supprimée. Le numéro de référence 9 désigne un témoin de signalisation de l'état de charge de la batterie 4.

Le dispositif émetteur 6 est réalisé sous forme d'un clavier et comporte un sélecteur de tension de référence 11, un sélecteur 12 d'organes ou d'appareils 8 à ne plus alimenter en tension de façon permanente ainsi qu'un bouton 13 de mise en veille du calculateur de bord 2, et, le cas échéant, du récepteur 3.

Les numéros de référence 14 et 15 désignent schématiquement les antennes d'émission et de réception du dispositif émetteur 6 et du récepteur de télécommande 3 du véhicule.

Le système de surveillance de l'état de charge de la batterie 4 d'un véhicule 1 se trouvant par exemple depuis plusieurs semaines sur un parking fonctionne de la manière suivante. Après avoir, le cas échéant, décondamné par des moyens habituels, tels qu'une clé ou une télécommande, le véhicule, on envoie à l'aide du dispositif émetteur 6 un signal de demande de mesure de la tension de la batterie au récepteur 3 du véhicule qui le transmet au calculateur 2. Ce signal est codé selon le choix de la tension de référence fait au niveau du sélecteur 11 du dispositif 6 et réveille dans le calculateur 2 la fonction "Mesure de tension de batterie". Le calculateur 2 compare alors la tension mesurée à celle qui, parmi les tensions qu'il a en mémoire, correspond à celle déterminée par le code du signal et choisie à l'aide du sélecteur 11.

L'acquittement de l'exécution des opérations de mesure et de comparaison est signalé sous forme d'un clignotement du témoin 9 situé dans le combiné 5. Ce clignotement est visible depuis l'extérieur du véhicule, sans nécessité de l'ouverture d'une porte. Si la tension de la batterie est supérieure à la tension de référence sélectionnée, le clignotement change de fréquence, sinon il se poursuit quelques instants, puis s'arrête.

Pour connaître la tension de la batterie, on procède par étapes en commençant par la tension de référence la plus élevée. Si le témoin signale que la tension de batterie n'est pas supérieure à la tension de référence sélectionnée, on envoie la tension de référence immédiatement inférieure jusqu'à ce que le témoin indique que la tension de batterie est plus grande que la tension de référence envoyée par le dispositif émetteur 6. Ainsi, il est possible de connaître l'état de charge de la batterie avec une précision qui ne dépend que du nombre de tensions de référence prévues dans le sélecteur 11 et des niveaux de tension en mémoire dans le caculateur 2.

Suivant l'état de la batterie, l'action sur l'un des boutons du sélecteur 12 permet de couper l'un ou l'autre des consommateurs permanents 8 par l'intermédiaire du calculateur 2. Cette mesure permet de prolonger le stockage du véhicule sur le parking sans risque de décharge totale de la batterie. Le bouton poussoir 13 permet de commander la mise en veille du calculateur 2 de façon à limiter la décharge de la batterie. En dernier ressort, l'un des boutons du sélecteur 12 permet la suppression de l'état de veille du récepteur de télécommande 3 et du calculateur 2.

Dans une autre version de réalisation du système selon l'invention, on peut également envisager d'équiper le calculateur de bord 2 d'un émetteur radio qui, sur commande, envoie un signal représentatif de la tension de batterie. Un véhicule circulant le long des rangées de véhicules stationnés sur le parking et équipé d'un dispositif émetteur avec ordinateur associé interroge alors successivement tous les véhicules stockés et établit par exemple sur fichier la liste des véhicules avec leurs tensions de batterie communiquées par l'émetteur radio de bord. En connaissant ainsi l'état de charge des batteries des véhicules se trouvant sur le parking, il est possible de dégager en priorité du parc les véhicules à bas état de charge de la batterie, avant qu'intervienne un débranchement automatique programmé lors de la descente de la tension de batterie en dessous d'un seuil prédéterminé. Ceci permet d'éviter les inconvénients d'un débranchement d'organes à consommation permanente et pourvus d'une mémoire destinée à une programmation liée à une utilisation propre ou à un apprentissage. En effet, après un débranchement de batterie, il faut remettre à l'heure les différentes horloges du véhicule ou de ses fonctions embarquées et procéder à des reprogrammations, comme par exemple des stations radio.

On notera que, de préférence dans cette application, le véhicule commence par émettre son identifiant (gardé en mémoire dans le calculateur de bord 2) pour permettre une saisie totalement automatique des données (véhicule interrogé et état de la batterie).

L'interrogation périodique des batteries des différents véhicules stockés sur le parc permet à l'opérateur de l'interrogation d'intervenir pour anticiper ou retarder le débranchement en fonction de la connaissance de la durée prévisionnelle du stockage sur le parc des véhicules et, le cas échéant, d'effectuer manuellement le débranchement pour des véhicules devant rester encore longtemps sur le parc.

## Revendications

1. procédé de surveillance de l'état de charge d'une batterie, notamment d'un véhicule automobile (1) équipé d'un calculateur de bord (2), selon lequel on indique l'état de charge de la batterie (4), d'une façon perceptible de l'extérieur du véhicule, **caractérisé en ce que** l'on utilise un émetteur extérieur (6) pour envoyer au calculateur (2) un signal de commande de mesure de la tension de la batterie (4) et de comparaison de cette tension mesurée à une valeur de tension de référence prédéterminée, que le signal de demande de mesure de la tension de la batterie comporte une indication de la tension de référence et **en ce que** l'indication, perceptible de l'extérieur du véhicule, est l'indication du résultat de la comparaison.

2. Procédé selon la revendication 1, **caractérisé en ce que** l'indication du résultat de la comparaison est donnée sous forme d'un signal lumineux.

3. Procédé selon l'une des revendications précédentes, **caractérisé en ce que** l'on procède par étapes par envois successifs de signaux de demande de mesure et de comparaison depuis une tension de référence maximale jusqu'à une tension de référence minimale.

4. Procédé selon l'une des revendications précédentes, **caractérisé en ce que** l'on prévoit, à des tensions de référence prédéterminées basses, la coupure de l'un ou l'autre des consommateurs d'énergie électrique (8) par l'intermédiaire du calculateur (2).

5. Procédé selon la revendication 4, **caractérisé en ce que**, pour une tension de référence encore inférieure, on supprime l'état de veille du calculateur (2) et du récepteur de télécommande (3) associé au calculateur pour la réception des signaux de demande précités.

6. Procédé selon l'une des revendications précédentes, **caractérisé en ce que**, pour des véhicules stockés sur un parking, on équipe le calculateur de bord (2) de chaque véhicule (1) d'un émetteur radio qui, sur interrogation, envoie un signal indicateur de la tension de la batterie du véhicule, on fait circuler un véhicule d'interrogation équipé d'un dispositif émetteur (6) de signaux d'interrogation de l'état de charge de batterie le long des rangées de véhicules et on établit une liste des véhicules interrogés avec leur tension de batterie, pour pouvoir dégager prioritairement du parking les véhicules à bas état de charge de la batterie.

7. Système pour la mise en oeuvre du procédé selon l'une des revendications 1 à 6, **caractérisé en ce qu'**il comporte un poste émetteur (6) des demandes de mesure et de comparaison, qui comporte un sélecteur d'un certain nombre de tensions de référence (11).

8. Système selon la revendication 7, **caractérisé en ce que** le calculateur de bord (2) est programmé pour mesurer la tension de la batterie du véhicule en réponse à un signal de demande de mesure et garde en mémoire les tensions de référence précitées.

9. Système selon la revendication 7 ou 8, **caractérisé en ce que** le dispositif émetteur (6) comprend des organes (12, 13) de mise en veille du calculateur (2) et de coupure de consommateurs d'énergie électrique installés dans le véhicule.

10. Système selon l'une des revendications 7 à 9, **caractérisé en ce qu'**il comprend un témoin émetteur d'un signal lumineux pour indiquer le résultat d'une comparaison d'une tension de batterie mesurée et de la tension de référence associée, l'organe étant prévu avantageusement sur le récepteur de télécommande (3) des signaux de demande émis par le dispositif émetteur extérieur (6).

## Claims

1. A method for monitoring the state of charge of a battery, notably of a motor vehicle (1) equipped with an onboard computer (2), according to which the state of charge of the battery (4) is indicated in a perceptible way from the outside of the vehicle, **characterized in that** an external transmitter (6) is used for sending to the computer (2), a control signal for measuring the voltage of the battery (4) and a signal for comparing this measure voltage with a predetermined reference voltage value, **in that** the signal requesting measurement of the voltage of the battery includes an indication of the reference voltage and **in that** the indication perceptible from the outside of the vehicle is the indication of the result of the comparison.

2. The method according to claim 1, **characterized in that** the indication of the result of the comparison is provided as an optical signal.

3. The method according to any of the preceding claims, **characterized in that** one proceeds stepwise by successively sending signals for requesting measurement and comparison, from a maximum reference voltage to a minimum reference voltage.

4. The method according to any of the preceding claims, **characterized in that** cutting off either one of the electrical power consuming devices (8) via the computer (2) is provided at predetermined low reference voltages.

5. The method according to claim 4, **characterized in that** for an even lower reference voltage, the standby condition of the computer (2) and of the remote control receiver (3) associated with the computer for receiving the aforementioned request signals is suppressed.

6. The method according to any of the preceding claims, **characterized in that**, for vehicles stored on a car park, the onboard computer (2) of each vehicle (1) is equipped with a radio transmitter which upon polling, sends a signal indicating the voltage of the battery of the vehicle, a polling vehicle equipped with a device (6) for transmitting signals for polling the state of charge of the battery is moved along rows of vehicles, and a list of polled vehicles with their battery voltage is established in order to be able to clear the vehicles with a low battery charge state with priority from the car park.

7. A system for applying the method according to any of claims 1 to 6, **characterized in that** it includes a station (6) transmitting measurement and comparison request, which includes a selector of a certain number of reference voltages (11).

8. The system according to claim 7, **characterized in that** the onboard computer (2) is programmed so as to measure the voltage of the battery of the vehicle in response to a measurement request signal, and saves the aforementioned reference voltages in memory.

9. The system according to claim 7 or 8, **characterized in that** the transmitting device (6) comprises units (12, 13) for setting the computer (2) into a standby state and for cutting off electric power consuming devices installed in the vehicle.

10. The system according to any of claims 7 to 9, **characterized in that** it comprises an indicator emitting an optical signal for indicating the result of a comparison of a measured battery voltage and the associated reference voltage, the unit being advantageously provided on the remote control receiver (3) of request signals transmitted by the external transmitting device (6).

## Patentansprüche

1. Verfahren zur Überwachung des Ladezustands einer Batterie, vor allem eines Kraftfahrzeugs (1), das mit einem Bordcomputer (2) ausgestattet ist, über den der Ladezustand der Batterie (4) derart angezeigt wird, dass er vom Fahrzeugäußeren aus wahrnehmbar ist, **dadurch gekennzeichnet, dass** ein Außensender (6) verwendet wird, um an den Computer (2) ein Steuersignal zur Messung der Spannung der Batterie (4) und zum Vergleich dieser gemessenen Spannung mit einem vorbestimmten Referenzspannungswert zu senden, dass das Signal zur Messung der Batteriespannung eine Anzeige der Referenzspannung umfasst und **dadurch**, dass die Anzeige, die vom Fahrzeugäußeren aus wahrnehmbar ist, die Anzeige des Ergebnisses des Vergleichs ist.

2. Verfahren nach Anspruch 1, **dadurch gekennzeichnet, dass** die Anzeige des Vergleichsergebnisses in Form eines Lichtsignals erfolgt.

3. Verfahren nach einem der vorhergehenden Ansprüche, **dadurch gekennzeichnet, dass** Signale zur Messung und zum Vergleich schrittweise und nacheinander ab einer maximalen Referenzspannung bis zu einer minimalen Referenzspannung gesendet werden.

4. Verfahren nach einem der vorhergehenden Ansprüche, **dadurch gekennzeichnet, dass** bei vorbestimmten niedrigen Referenzspannungen der eine oder andere Elektroenergieverbraucher (8) mit Hilfe des Computers (2) getrennt wird.

5. Verfahren nach Anspruch 4, **dadurch gekennzeichnet, dass** für eine noch niedrigere Referenzspannung der Überwachungszustand des Computers (2) und des mit dem Computer verbundenen Fernsteuerempfängers (3) für den Empfang der vorgenannten Anfragesignale ausgesetzt wird.

6. Verfahren nach einem der vorhergehenden Ansprüche, **dadurch gekennzeichnet, dass** der Bordcomputer (2) jedes Fahrzeugs (1) für auf einem Parkplatz abgestellte Fahrzeuge mit einem Funkempfänger ausgerüstet wird, der auf Anfrage ein die Spannung der Fahrzeugbatterie anzeigendes Signal sendet, dass ein mit einer Vorrichtung (6) zum Senden von Batterieladezustandsabfragesignalen ausgestattetes Abfragefahrzeug entlang der Reihen verkehrt und dass eine Liste der abgefragten Fahrzeuge mit ihrer Batteriespannung erstellt wird, um zuerst die Fahrzeuge von dem Parkplatz zu entfernen, deren Batterieladezustand niedrig ist.

7. System zur Umsetzung des Verfahrens nach einem der Ansprüche 1 bis 6, **dadurch gekennzeichnet, dass** es einen Sendeapparat (6) für die Mess- und Vergleichsanfragen umfasst, der eine Vorrichtung zur Auswahl einer bestimmten Anzahl von Referenzspannungen (11) umfasst.

8. System nach Anspruch 7, **dadurch gekennzeichnet, dass** der Bordcomputer (2) programmiert ist, um die Spannung der Fahrzeugbatterie in Beantwortung auf ein Messanforderungssignal zu messen und die vorgenannten Referenzspannungen im Speicher behält.

9. System nach Anspruch 7 oder 8, **dadurch gekennzeichnet, dass** die Sendevorrichtung (6) Organe (12, 13) umfasst, die den Computer (2) in einen Beobachtungszustand versetzen und die im Fahrzeug eingebauten Elektroenergieverbraucher trennen.

10. System nach einem der Ansprüche 7 bis 9, **dadurch gekennzeichnet, dass** es eine ein Lichtsignal aussendende Anzeige umfasst, die das Ergebnis eines Vergleichs einer gemessenen Batteriespannung mit der entsprechenden Referenzspannung anzeigt, wobei sich das Organ in vorteilhafter Weise auf dem ferngesteuerten Empfänger (3) der von der äußeren Sendevorrichtung (6) ausgesandten Anfragesignale befindet.
